# EUROPEAN PATENT SPECIFICATION

(11) **EP 3 327 497 B1**
(45) Date of publication and mention of the grant of the patent: **14.08.2019**
(21) Application number: 17188494.3
(22) Date of filing: 30.08.2017
(51) Int. Cl.: G02F 1/1368, H01L 29/786

(54) **PIXEL STRUCTURE AND DISPLAY DEVICE HAVING THE SAME**
PIXELSTRUKTUR UND ANZEIGEVORRICHTUNG DAMIT
STRUCTURE DE PIXEL ET DISPOSITIF D'AFFICHAGE LA COMPRENANT

(30) Priority: 28.11.2016 TW 105139119
(43) Date of publication of application: 30.05.2018
(73) Proprietor: AU Optronics Corporation, Hsin-Chu (TW)
(72) Inventor: Lee, Ming-Hsien, Hsin-Chu (TW)
(74) Representative: Jakelski & Althoff Patentanwälte PartG mbB

(56) References cited:
- JP-A- 2002 182 238
- US-A1- 2004 046 912
- US-A1- 2013 299 830

## Description

### BACKGROUND

### Technical Field

The present disclosure relates to a pixel structure and a display device having the same.

### Related Art

In various electronic products of home appliance devices, liquid crystal displays in which thin film transistors (TFT) are applied have been widely used. The TFT liquid crystal display mainly consists of a TFT array substrate, a color filter array substrate, and a liquid crystal layer. A plurality of TFTs that is arranged in an array and a pixel electrode that is configured corresponding to the TFT are disposed on the TFT array substrate.

However, in a pixel structure of the liquid crystal display, arrangement of liquid crystal molecules in a liquid crystal layer may be affected by the structure and topography, resulting in that the pixel structure cannot normally present a signal. Moreover, as resolution that a liquid crystal display can provide becomes increasing high, liquid crystal molecules are affected by the structure and topography more significantly. For this, how to effectively solve the foregoing problem is one of the important development topics at present, and is also an aspect to make improvement in the related field at present. JP2002182238A discloses a pixel structure according to the preamble of claim 1.

US2004046912A1 and US2013299830 disclose bump structures formed at the connection between a pixel electrode and the drain of a thin film transistor.

### SUMMARY

The invention is defined in the appended claims. An embodiment of the present disclosure provides a pixel structure, comprising a bump formed of a light shielding material, a first insulating layer, a semiconductive layer, a second insulating layer, a metal layer, and a planarization layer. The first insulating layer may protrude through a topographical form of the bump and a protruding portion may be formed. With the presence of the protruding portion, a height difference between the second insulating layer and the metal layer may be reduced, and topographical fluctuations of an upper surface of the planarization layer are reduced accordingly, so that liquid crystal molecules that are subsequently formed above the planarization layer are less affected by the topography, so as to further avoid disclination of liquid crystal molecules.

An embodiment of the present disclosure provides a pixel structure, disposed on a substrate, and comprising a bump, a first insulating layer, a semiconductive layer, a second insulating layer, a metal layer, and a pixel electrode. The bump is disposed on the substrate. The first insulating layer is disposed on the substrate and covers the bump. The first insulating layer has a protruding portion at a position at which the first insulating layer covers the bump. The semiconductive layer is disposed on the first insulating layer, and at least a portion of the semiconductive layer is disposed above the protruding portion. The second insulating layer is disposed on the first insulating layer and covers the semiconductive layer. The second insulating layer has a via, so as to make a portion of the semiconductive layer be not covered by the second insulating layer. The via corresponds to the protruding portion in a direction perpendicular to the substrate. The metal layer is electrically connected to the semiconductive layer through the via of the second insulating layer. A vertical projection of the bump on the substrate is present within a vertical projection of the metal layer on the substrate. The pixel electrode is electrically connected to the semiconductive layer.

In some embodiments, the pixel structure further comprises a planarization layer. The planarization layer covers the metal layer and the second insulating layer. The bump is located between the substrate and the planarization layer. The planarization layer has a concave portion. The concave portion is located on an upper surface of the planarization layer opposite the metal layer. A vertical projection of the concave portion on the substrate is at least partially overlapped with the via, and a maximum depth of the concave portion is less than 100 nanometers.

In some embodiments, the pixel structure further comprises the planarization layer and a display medium layer. The planarization layer covers the metal layer and the second insulating layer, and the bump is located between the substrate and the planarization layer. The display medium layer is disposed on the planarization layer, and has a plurality of display media.

In some embodiments, the vertical projection of the bump on the substrate extends from inside of the via to outside of the via along an extending direction of the metal layer.

In some embodiments, a thickness of the bump is T1, a thickness of the semiconductive layer is T2, and 1.5≤ (T1/T2) ≤5.

In some embodiments, a thickness of the bump is T1, and 100 nanometers ≤T1≤250 nanometers.

In some embodiments, the first insulating layer and the second insulating layer are respectively formed of a single dielectric layer or a plurality of dielectric layers.

In some embodiments, at least partial of the metal layer is adapted as a data line, and at least a portion of the semiconductive layer has an extending direction substantially the same as an extending direction of the data line.

In some embodiments, at least a portion of the semiconductive layer is disposed overlapping the metal layer in a direction perpendicular to the substrate.

In some embodiments, the pixel structure further comprises a light-shielding layer. The light-shielding layer is disposed above on the substrate. The metal layer be located between the light-shielding layer and the bump. The vertical projection of the bump on the substrate is present within a vertical projection of the light-shielding layer on the substrate.

An embodiment of the present disclosure provides a display device, comprising a display panel and a pixel structure. The display panel has a display zone and a peripheral zone. The peripheral zone is adjacent to the display zone. The pixel structure is disposed inside the display zone of the display panel.

### BRIEF DESCRIPTION OF THE DRAWINGS

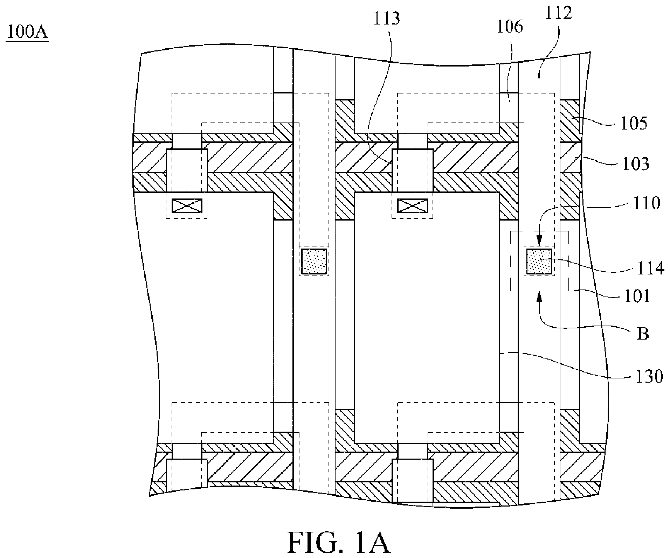

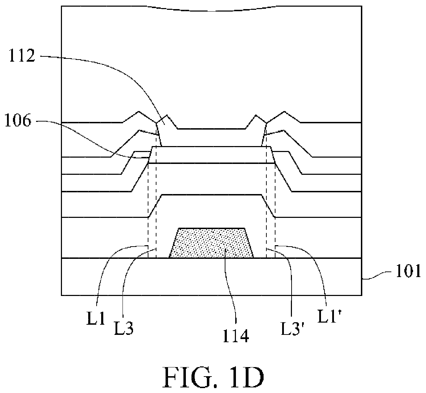

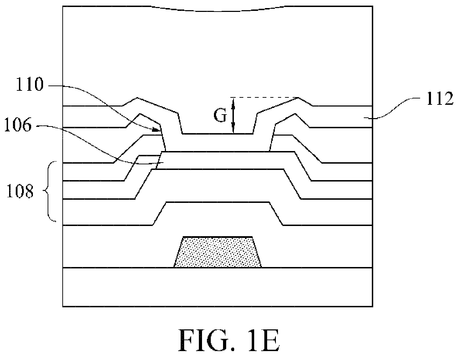

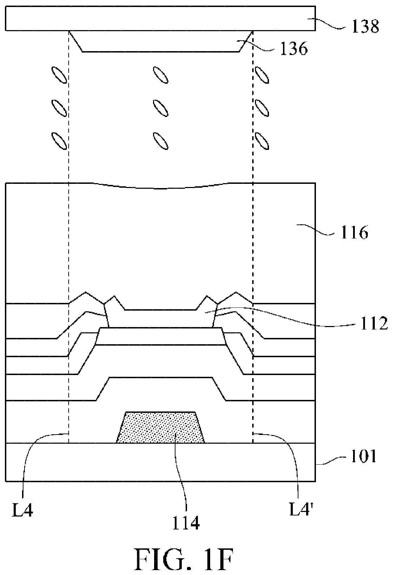

FIG. 1A is a schematic top view of a pixel structure according to the present disclosure in a first embodiment.
FIG. IB is an enlarged view of an area B of the pixel structure in FIG. 1A.

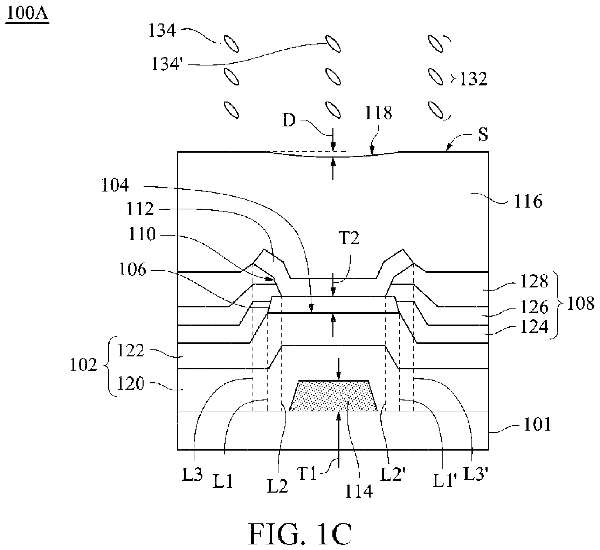

FIG. 1C is a cross-sectional view along section line 1C-1C in FIG. IB.
FIG. ID is a cross-sectional view of the pixel structure in some embodiments, where a sectional position in FIG. ID is the same as that in FIG. 1C.
FIG. IE is a cross-sectional view along section line IE-IE in FIG. IB.
FIG. IF is a cross-sectional view of the structure in FIG. 1C and a light-shielding layer on the structure.
FIG. 2 is a schematic top view of a pixel structure according to the present disclosure in a second embodiment.
FIG. 3 is a schematic top view of some embodiments of a display device according to the present disclosure.

### DETAILED DESCRIPTION

In present disclosure, when an element is "connected" or "coupled", it may indicate that the element is "electrically connected" or "electrically coupled". "Connected" or "coupled" may further be used to indicate that two or more elements operate cooperatively or interact with each other. Oppositely, when an element is "directly on another element" or "directly connected to" another element, there is no intermediate element. As used herein, "connection" may refer to physical and/or electrical connection.

In the drawings, the thickness of layers, films, panels, regions, etc., are exaggerated for clarity. Like reference numerals designate like elements throughout the specification. It will be understood that when an element such as a layer, film, region, or substrate is referred to as being "on" or "above" another element, it can be directly on or directly above the other element or intervening elements may also be present. In contrast, when an element is referred to as being "directly on" or "directly above" or "contact" another element, there are no intervening elements present.

The terms used herein are merely used for describing specific embodiments, and are not limitative. As used herein, unless otherwise clearly indicated in the content, singular forms "a", "one", and "the" are intended to include plural forms, and include "at least one". "Or" indicates "and/or".

As used herein, "about", "similar", or "substantially" includes the value and an average value of values in an acceptable deviation range of a specific value determined by a person of ordinary skill in the art, taking the discussed measurement and a specific quantity of errors related to the measurement (that is, limitations of a measurement system) into consideration. For example, "about" may indicate within one or more standard deviations of the value, or within ±20%, ±10%, or ±5%.

A pixel structure of the present disclosure includes a bump, a first insulating layer, a semiconductive layer, a second insulating layer, a metal layer, and a planarization layer. The first insulating layer may protrude through a topographical form of the bump and a protruding portion may be formed. With the presence of the protruding portion, a height difference between the second insulating layer and the metal layer may be reduced, and topographical fluctuations of an upper surface of the planarization layer are reduced accordingly, so that liquid crystal molecules that are subsequently formed above the planarization layer are less affected by the topography, so as to further avoid light leakage caused by disclination of liquid crystal molecules.

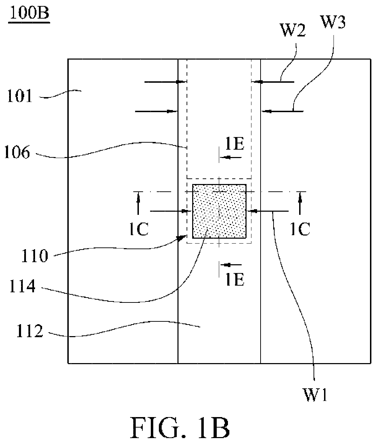

Referring to FIG. 1A, FIG. 1B, and FIG. 1C. FIG. 1A is a schematic top view of a pixel structure 100A according to the present disclosure in a first embodiment. FIG. IB is an enlarged view of an area B of the pixel structure 100A in FIG. 1A. FIG. 1C is a cross-sectional view along section line 1C-1C in FIG. IB. To clearly represent a position of a bump 114, the bump 114 in FIG. 1A, FIG. 1B, and FIG. 1C is drawn in a mesh form. The pixel structure 100A may be disposed on a substrate 101, and the pixel structure 100A includes a first insulating layer 102, a gate line 103, a light-shielding portion 105, a semiconductive layer 106, a second insulating layer 108, a metal layer 112, the bump 114, a planarization layer 116, and a pixel electrode 130.

The light-shielding portion 105 is, for example, a light-shielding metal, and may be selectively disposed on the substrate 101. The gate line 103 is located on the light-shielding portion 105. At least one insulating layer may be disposed between the gate line 103 and the light-shielding portion 105. The gate line 103 may be at the same time used as a gate electrode and a gate line. The metal layer 112 may be at the same time used as a source electrode and a data line. A plurality of gate lines 103 and a plurality of metal layers 112 (for example, the data lines) may be interlaced (or namely intersected, or namely crossover) with each other to define a plurality of pixel areas. The pixel electrode 130 is correspondingly disposed in the defined pixel area. The metal layer 112 is connected to the semiconductive layer 106 through a via 110. At least a portion of the semiconductive layer 106 has an extending direction the same as an extending direction of the metal layer 112 and vertical projections of the at least a portion of the semiconductive layer 106 and the metal layer 112 on the substrate 101 are overlapped with each other. At least a portion of the semiconductive layer 106 and the gate line 103 are interlaced with each other. The gate line 103, the semiconductive layer 106, the metal layer 112, and a conductive layer 113 together form a transistor structure. The pixel electrode 130 is electrically connected to the conductive layer 113, and the conductive layer 113 is electrically connected to the semiconductive layer 106. In other words, the conductive layer 113 can be as a drain electrode of a transistor structure.

The bump 114 is disposed on the substrate 101, and has a thickness T1. The bump 114 is formed of a light-shielding material. In an embodiment in which the bump 114 is formed of a light-shielding material, the material of the bump 114 may be a metal material, and the thickness T1 of the bump 114 may be adjusted according to light-shielding characteristics of the metal material. In some embodiment, the material of the bump 114 may be alloy or other suitable materials. For example, if a characteristic relationship between thickness and light transmittance of a used metal material is "when the thickness of the metal material is X units, the metal material has light transmittance less than about 0.1%", in such a characteristic relationship, the thickness T1 of the bump 114 substantially may be greater than or equal to 5X units and less than or equal to 15X units, that is, 5X≤ T1 ≤15X. In other words, the thickness T1 of the bump 114 is greater than a thickness that exists when a light-shielding condition is met. The foregoing range of thickness is applicable to the thickness T1 of the bump 114 formed of a metal material. However, the thickness T1 of the bump 114 may be greater than or substantially equal to 100 nanometers (nm) and less than or substantially equal to 250 nm, that is, 100 nm ≤ T1 ≤250 nm.

The first insulating layer 102 is disposed on the substrate 101, and covers the bump 114. The first insulating layer 102 may be formed of a single dielectric layer or a plurality of dielectric layers. For example, in this embodiment, the first insulating layer 102 may be formed of two dielectric layers. One of the two dielectric layers is as a first buffer layer 120, and the other of the two dielectric layers is as a second buffer layer 122. The first buffer layer 120 is disposed on the substrate 101 and covers the bump 114. The second buffer layer 122 covers the first buffer layer 120. The first buffer layer 120 may be silicon nitride (SiNx) or silicon nitroxide (SiOxNy). The second buffer layer 122 may be silicon oxide (SiOx) or silicon nitroxide (SiOxNy). In this embodiment, with the presence of the bump 114, the first insulating layer 102 may protrude through a topographical form of the bump 114 and a protruding portion 104 may be formed. In other words, the protruding portion 104 exists above a position at which the first insulating layer 102 covers the bump 114.

The semiconductive layer 106 is disposed on the first insulating layer 102 and is at least located on the protruding portion 104 of the first insulating layer 102, that is, the vertical projection of the semiconductive layer 106 on the substrate 101 is at least partially overlapped with a vertical projection of the bump 114 on the substrate 101. In this embodiment, the vertical projection of the bump 114 on the substrate 101 is present within the vertical projection of the semiconductive layer 106 on the substrate 101, for example, the range of the semiconductive layer 106 between a dotted line L1 and a dotted line L1' in FIG. 1C. Specifically, the bump 114 has a width W1, the semiconductive layer 106 has a width W2, and the width W1 of the bump 114 is less than the width W2 of the semiconductive layer 106. A width relationship between the bump 114 and the semiconductive layer 106 is shown in FIG. IB and/or FIG. 1C. In addition, the semiconductive layer 106 has a thickness T2, and a ratio of the thickness T1 of the bump 114 to the thickness T2 of the semiconductive layer 106 is greater than or substantially equal to 1.5 and is less than or substantially equal to 5, that is, 1.5≤ (T1/T2) ≤5. In addition, the semiconductive layer 106 may be used as a channel zone of a TFT (not shown), or is doped to become a source zone and a drain zone of the TFT. A material of the semiconductive layer 106 may be polycrystalline silicon or a metal oxide semiconductor. In addition, the semiconductive layer 106 is electrically connected to the pixel electrode 130. For example, the semiconductive layer 106 may be electrically connected to the pixel electrode 130 through the conductive layer 113 that is located between the semiconductive layer 106 and the pixel electrode 130.

The second insulating layer 108 is disposed on the first insulating layer 102 and covers the semiconductive layer 106. The second insulating layer 108 may be formed of a single dielectric layer or a plurality of dielectric layers. For example, in this embodiment, the second insulating layer 108 may be formed of three dielectric layers, which are respectively a gate insulating layer 124, a first barrier layer 126, and a second barrier layer 128. The gate insulating layer 124 is disposed on the first insulating layer 102. The gate line 103 is disposed on the gate insulating layer 124. The gate insulating layer 124 may be at least electrically isolate the gate line 103 and the semiconductive layer 106 in FIG. 1A at a position at which the gate line 103 and the semiconductive layer 106 are overlapped. The first isolation layer 126 is disposed on the gate insulating layer 124. The second isolation layer 128 is disposed on the first isolation layer 126. The first isolation layer 126 may be silicon oxide (SiOx), silicon nitride (SiNx) or silicon nitroxide (SiOxNy). The second isolation layer 128 may be silicon nitride (SiNx), silicon oxide (SiOx) or silicon nitroxide (SiOxNy).

The second insulating layer 108 has the via 110. The via 110 is located above the semiconductive layer 106 and penetrates the gate insulating layer 124, the first isolation layer 126, and the second isolation layer 128, so as to make a portion of the semiconductive layer 106 be not covered by the second insulating layer 108. In other words, the semiconductive layer 106 that is located between the via 110 and the protruding portion 104 may be exposed from the second insulating layer 108 through the via 110. In another aspect, a position at which the via 110 is provided may correspond to a position of the protruding portion 104. For example, the via 110 corresponds to the protruding portion 104 in a direction perpendicular to the substrate 101. In addition, according to the foregoing description, because the first insulating layer 102 has the protruding portion 104 at the position at which the first insulating layer 102 covers the bump 114, the vertical projection of the bump 114 on the substrate 101 is present within a boundary range of a vertical projection of the via 110 on the substrate 101 of the second insulating layer 108. For example, the bump 114 shown in FIG. 1C is present within a range of the via 110 between a dotted line L2 and a dotted line L2'.

The metal layer 112 is disposed on the second insulating layer 108, and is electrically connected to the semiconductive layer 106 through the via 110 of the second insulating layer 108. That is, the metal layer 112 through the via 110 may contact the semiconductive layer 106 is exposed by the via 110 to form an electrical connection between the metal layer 112 and the semiconductive layer 106. In addition, the vertical projection of the bump 114 on the substrate 101 is present within the vertical projection of the metal layer 112 on the substrate 101, for example, within a range of the metal layer 112 between a dotted line L3 and a dotted line L3' in FIG. 1C. Specifically, the metal layer 112 has a width W3. The width W1 of the bump is less than the width W3 of the metal layer 112. A width relationship between the bump and the metal layer 112 is shown in FIG. IB and/or FIG. 1C. By means of this size configuration relationship, the disposed bump 114 does not affect an aperture ratio of the pixel structure 100A. In addition, the vertical projection of the metal layer 112 on the substrate 101 is located outside of a vertical projection of the pixel electrode 130 on the substrate 101. The metal layer 112 may be used as a data line of the pixel structure 100A, so that the pixel electrode 130 can be driven by using the gate line 103, the semiconductive layer 106, and the metal layer 112. In another aspect, the foregoing conductive layer 113 that is located between the semiconductive layer 106 and the pixel electrode 130 may be formed by using a process the same as that of the metal layer 112. That is, the conductive layer 113 and the metal layer 112 may be formed by using a same film material.

In addition, although the width W3 of the metal layer 112 is greater than the width W2 of the semiconductive layer 106 in FIG. IB and FIG. 1C, in another embodiment, the width W3 of the metal layer 112 may be less than or substantially equal to the width W2 of the semiconductive layer 106. For example, referring to FIG. ID, FIG. ID is a cross-sectional view of the pixel structure in some embodiments. A cross-sectional position in FIG. ID is the same as that in FIG. 1C. In FIG. ID, the width of the metal layer 112 is less than the width of the semiconductive layer 106. Therefore, the range of the semiconductive layer 106 between the dotted line L1 and the dotted line L1' is greater than the range of the metal layer 112 between the dotted line L3 and the dotted line L3'. However, regardless of a width relationship between the semiconductive layer 106 and the metal layer 112, the vertical projection of the bump 114 on the substrate 101 is still present within the vertical projections of the semiconductive layer 106 and the metal layer 112 on the substrate 101. In other words, the width of the bump 114 is still less than the width of either of the semiconductive layer 106 and the metal layer 112.

Referring to FIG. IB and FIG. 1C again. By means of the foregoing configuration, because the protruding portion 104 may be formed through the bump 114 on the first insulating layer 102 at the position at which the first insulating layer 102 covers the bump 114, a topographical segment difference between the second insulating layer 108 and the metal layer 112 that is located inside the via 110 above the protruding portion 104 may be reduced. For example, refer to FIG. IB and FIG. IE. FIG. IE is a cross-sectional view along section line IE-IE in FIG. IB. FIG. IE mainly shows that a height difference G exists between the metal layer 112 inside the via 110 and the metal layer 112 outside the via 110. By means of the foregoing configuration, when the metal layer 112 on the second insulating layer 108 contacts the semiconductive layer 106 through the via 110, the height difference G of the metal layer 112 can also be reduced.

Specifically, a vertical distance between the substrate 101 and the metal layer 112 located inside the via 110 may increase because the protruding portion 104 is present, so as to reduce a height difference between an upper surface of the second insulating layer 108 and an upper surface of the metal layer 112 located inside the via 110, and a surface on which the planarization layer 116 is to be disposed is provided accordingly. Referring to the following description for details.

As shown in FIG. 1C, the planarization layer 116 covers the second insulating layer 108 and the metal layer 112. The planarization layer 116 has an upper surface S opposite the substrate 101 (such as inner surface of the substrate 101). After the planarization layer 116 is formed on the second insulating layer 108 and the metal layer 112, the upper surface S of the planarization layer 116 has fluctuating topography (or namely undulating topography, or namely rise and fall topography) corresponding to the second insulating layer 108 and the metal layer 112. For example, because a portion of the metal layer 112 is present within the via 110 and contacts the semiconductive layer 106, slight settlement (or namely slight concave) exist at the position corresponding to the via 110 on the upper surface S of the planarization layer 116.

For this, because the bump 114 and the protruding portion 104 may reduce the height difference between the upper surface of the second insulating layer 108 and the upper surface of the metal layer 112 located inside the via 110, a settlement degree (or namely settlement amount) of these slight settlement may also be reduced. Specifically, in FIG. 1C, the planarization layer 116 has a concave portion (or namely settlement portion) 118, and a vertical projection of the concave portion 118 on the substrate 101 is at least partially overlapped with the vertical projection of the via 110 on the substrate 101. The concave portion 118 has a maximum depth D, and the maximum depth D of the concave portion 118 is less than about 100 nm. By reducing a settlement degree of the concave portion 118, topographical fluctuations that exist on the upper surface S of the planarization layer 116 are also relatively reduced, so as to prevent a subsequent structure from being affected by the topographical fluctuations. For example, as shown in FIG. 1C, a display medium layer 132 disposed on the planarization layer 116 has a plurality of display media 134. The display medium 134 may be liquid crystal molecules, and a vertical projection of a portion of the display medium 134 on the substrate 101 is present within the vertical projection of the bump 114 on the substrate 101. The portion of the display medium 134 is, for example, a display medium 134'. Because the topographical fluctuations of the upper surface S of the planarization layer 116 are relatively reduced, the display medium 134' may be less affected by the topography, so as to further avoid disclination, so as to further avoid light leakage.

In addition, refer to FIG. IF. FIG. IF is a cross-sectional view of the structure in FIG. 1C and a light-shielding layer 136 on the structure. The pixel structure 100A may also include the light-shielding layer 136. The light-shielding layer 136 may be disposed on an opposite substrate 138, and may be located above the planarization layer 116. The metal layer 112 is located between the light-shielding layer 136 and the bump 114. The vertical projection of the bump 114 on the substrate 101 is present within a vertical projection of the light-shielding layer 136 on the substrate 101, for example, a range between a dotted line L4 and a dotted line L4'. By means of this size configuration relationship, the disposed bump 114 does not affect the aperture ratio of the pixel structure 100A. Therefore, while the aperture ratio is maintained, the pixel structure 100A reduces the height difference between the second insulating layer 108 and the metal layer 112 inside the via 110. In addition, in another embodiment, the vertical projection of the bump 114 on the substrate 101 only needs to be present within at least one of the vertical projection of the metal layer 112 on the substrate 101 and the vertical projection of the light-shielding layer 136 on the substrate 101.

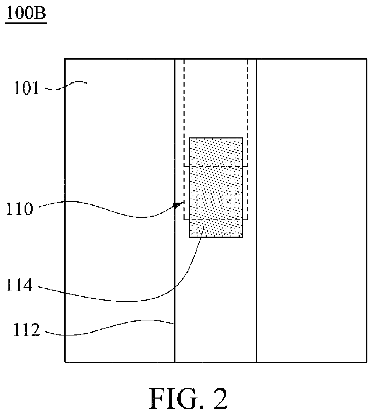

Referring to FIG. 2 again. FIG. 2 is a schematic top view of a pixel structure 100B according to the present disclosure in a second embodiment. A viewing angle of FIG. 2 is the same as that of FIG. IB. At least one difference of this embodiment from the first embodiment is that the bump 114 in this embodiment has a relatively large area, to enable the vertical projection of the bump 114 on the substrate 101 to extend from inside of the via 110 to outside of the via 110 along an extending direction of the metal layer 112. For this, the length of the bump 114 is increased without changing the width. Because the position at which the bump 114 is disposed may correspondingly extend outside the via 110 from inside the via 110, the design of the pixel structure 100B may be more flexible. In addition, the vertical projection of the bump 114 on the substrate 101 is still present within the vertical projection of the metal layer 112 on the substrate 101, so that the disposed bump 114 does not affect an aperture ratio of the pixel structure 100B.

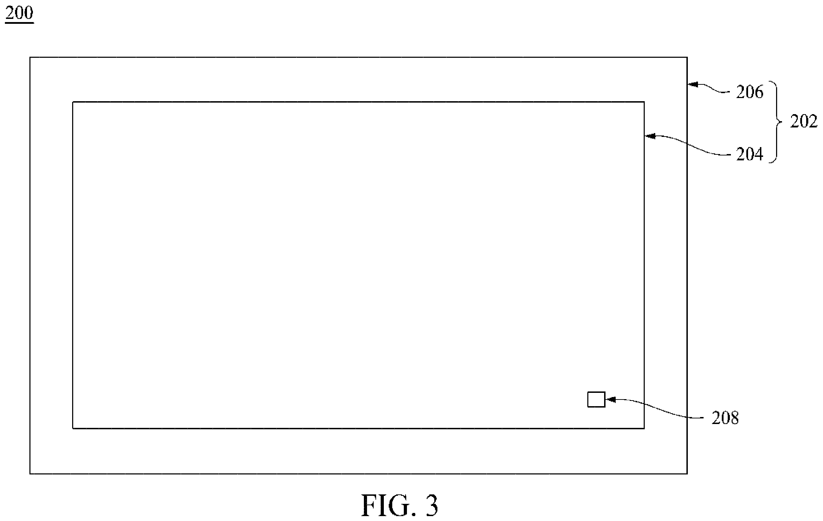

The pixel structure 100A or 100B in the foregoing first embodiment or the second embodiment is applicable to a display device. For example, referring to FIG. 3, FIG. 3 is a schematic top view of some embodiments of a display device 200 according to the present disclosure. The display device 200 includes a display panel 202 and a pixel structure 208. The display panel 202 has a display zone 204 and a peripheral zone 206. The peripheral zone 206 is adjacent to the display zone 204, for example, the peripheral zone 206 is surrounding to the display zone 204. The pixel structure 208 is disposed inside the display zone 204 of the display panel 202. The disposed pixel structure 208 may be the pixel structure 100A or 100B (that is, including a bump disposed therein) described in the foregoing first embodiment or second embodiment. In addition, for simplicity of the drawing, one pixel structure 208 is shown in FIG. 3.

The display zone 204 may output an image by using liquid crystal molecules (not shown) inside the display zone 204. Similar to the above, because the pixel structure 208 that includes a bump may reduce a settlement degree of the topography inside the structure, disclination of the liquid crystal molecules of the display zone 204 can be avoided, and a problem that the display zone 204 cannot normally output an image or that brightness is uneven is further avoided. In another aspect, because the peripheral zone 206 does not need to output an image, it can be flexibly chosen whether the pixel structure that includes the bump is to be disposed inside the peripheral zone 206. For example, in some embodiments, the pixel structure 208 that includes the bump is only disposed in the display zone 204, and the pixel structure that is disposed on the peripheral zone 206 does not include the bump. However, the present disclosure is not limited thereto. In another embodiment, the pixel structure 208 that includes the bump may is disposed in both the display zone 204 and the peripheral zone 206.

In conclusion, the pixel structure of the present disclosure includes a bump formed of a light shielding material, a first insulating layer, a semiconductive layer, a second insulating layer, a metal layer, and a planarization layer. The first insulating layer may protrude through a topographical form of the bump and a protruding portion may be formed. With the presence of the protruding portion, a height difference between the second insulating layer and the metal layer may be reduced, and topographical fluctuations of an upper surface of the planarization layer are reduced accordingly, so that liquid crystal molecules that are subsequently formed above the planarization layer are less affected by the topography, so as to further avoid disclination of the liquid crystal molecules. In another aspect, an area of the bump may be less than that of the metal layer and a light-shielding layer, so that the presence of the bump does not affect an aperture ratio of the pixel structure. That is, while the aperture ratio is maintained, the pixel structure reduces a height difference between the second insulating layer and the metal layer.

## Claims

1. A pixel structure (100A and 100B), disposed on a substrate (101), and comprising:
a bump (114), disposed on the substrate (101);
a first insulating layer (102), disposed on the substrate (101) and covering the bump (114), wherein the first insulating layer (102) has a protruding portion (104) where the first insulating layer (102) covers the bump (114);
a semiconductive layer (106), disposed on the protruding portion (104);
a second insulating layer (108), disposed on the first insulating layer (102) and the semiconductive layer (106), wherein the second insulating layer (108) has a via (110) positioned above the protruding portion (104) and exposing the semiconductive layer (106);
a metal layer (112), disposed on the second insulating layer (108) and electrically connected to the semiconductive layer (106) through the via (110), wherein the bump (114) is present within a vertical projection of the metal layer (112) on the substrate (101); and
a pixel electrode (130), electrically connected to the semiconductive layer (106) and **characterized in that** the bump (114) is formed of a light-shielding material.

2. The pixel structure (100A and 100B) according to claim 1, **characterized by** further comprising:
a planarization layer (116), covering the metal layer (112) and the second insulating layer (108), wherein the bump (114) is located between the substrate (101) and the planarization layer (116), the planarization layer (116) has a concave portion (118), the concave portion (118) is located on an upper surface (S) of the planarization layer (116) opposite the metal layer (112), the concave portion (118) is at least partially overlapped with the via (110), and a maximum depth of the concave portion (118) is less than 100 nanometer.

3. The pixel structure (100A and 100B) according to claim 1, **characterized by** further comprising:
a planarization layer (116), covering the metal layer (112) and the second insulating layer (108), wherein the bump (114) is located between the substrate (101) and the planarization layer (116); and
a display medium layer (132), disposed on the planarization layer (116), having a plurality of display media (134).

4. The pixel structure (100A and 100B) according to claim 1, **characterized in that** the vertical projection of the bump (114) on the substrate (101) extends from inside of the via (110) to outside of the via (110) along an extending direction of the metal layer (112).

5. The pixel structure (100A and 100B) according to claim 1, **characterized in that** a thickness of the bump (114) is T1, a thickness of the semiconductive layer (106) is T2, and 1.5≤ (T1/T2) ≤5.

6. The pixel structure (100A and 100B) according to claim 1, **characterized in that** a thickness of the bump (114) is T1, and 100 nanometer ≤T1≤250 nanometer.

7. The pixel structure (100A and 100B) according to claim 1, **characterized in that** the first insulating layer (102) and the second insulating layer (108) are respectively formed of a single dielectric layer or a plurality of dielectric layers.

8. The pixel structure (100A and 100B) according to claim 1, **characterized in that** at least a portion of the metal layer (112) is adapted as a data line, and the at least a portion of the semiconductive layer (106) extends in the same direction as the data line extends.

9. The pixel structure (100A and 100B) according to claim 8, **characterized in that** the at least a portion of the semiconductive layer (106) is disposed overlapping the metal layer (112) in a direction perpendicular to the substrate (101).

10. The pixel structure (100A and 100B) according to claim 1, **characterized by** further comprising:
a light-shielding layer (136), disposed above on the substrate (101) and above the bump (114), wherein the metal layer (112) is located between the light-shielding layer (136) and the bump (114).

11. A display device (200), **characterized by** comprising:
a display panel (202), having a display zone (204) and a peripheral zone (206), wherein the peripheral zone (206) is adjacent to the display zone (204); and
the pixel structure (208) of claim 1, disposed inside the display zone (204).

## Patentansprüche

1. Pixelstruktur (100A und 100B), die auf einem Substrat (101) angeordnet ist und Folgendes umfasst:
einen Höcker (114), der auf dem Substrat (101) angeordnet ist;
eine erste Isolierschicht (102), die auf dem Substrat (101) angeordnet ist und den Höcker (114) abdeckt, wobei die erste Isolierschicht (102), dort wo die Isolierschicht (102) den Höcker (114) abdeckt, einen vorstehenden Abschnitt (104) aufweist;
eine Halbleiterschicht (106), die auf dem vorstehenden Abschnitt (104) angeordnet ist;
eine zweite Isolierschicht (108), die auf der ersten Isolierschicht (102) und der Halbleiterschicht (106) angeordnet ist, wobei die zweite Isolierschicht (108) eine Durchkontaktierung (110) aufweist, die über dem vorstehenden Abschnitt (104) positioniert ist und die Halbleiterschicht (106) freilegt;
eine Metallschicht (112), die auf der zweiten Isolierschicht (108) angeordnet ist und elektrisch durch die Durchkontaktierung (110) mit der Halbleiterschicht (106) verbunden ist, wobei der Höcker (114) innerhalb eines vertikalen Vorsprungs der Metallschicht (112) auf dem Substrat (101) angeordnet ist; und
eine Pixelelektrode (130), die elektrisch mit der Halbleiterschicht (106) verbunden ist, **dadurch gekennzeichnet, dass** der Höcker (114) aus einem lichtabschirmenden Material gebildet ist.

2. Pixelstruktur (100A und 100B) nach Anspruch 1, **gekennzeichnet dadurch, dass** sie ferner Folgendes umfasst:
eine Planarisierungsschicht (116), die die Metallschicht (112) und die zweite Isolierschicht (108) abdeckt, wobei sich der Höcker (114) zwischen dem Substrat (101) und der Planarisierungsschicht (116) befindet, die Planarisierungsschicht (116) einen konkaven Abschnitt (118) aufweist, sich der konkave Abschnitt (118) an einer oberen Oberfläche (S) der Planarisierungsschicht (116) gegenüber der Metallschicht (112) befindet, der konkave Abschnitt (118) mindestens teilweise mit der Durchkontaktierung (110) überlappt ist und eine maximale Tiefe des konkaven Abschnitts (118) weniger als 100 Nanometer beträgt.

3. Pixelstruktur (100A und 100B) nach Anspruch 1, **gekennzeichnet dadurch, dass** sie ferner Folgendes umfasst;
eine Planarisierungsschicht (116), die die Metallschicht (112) und die zweite Isolierschicht (108) abdeckt, wobei sich der Höcker (114) zwischen dem Substrat (101) und der Planarisierungsschicht (116) befindet; und
eine Anzeigemediumsschicht (132), die auf der Planarisierungsschicht (116) angeordnet ist und eine Vielzahl von Anzeigemedien (134) aufweist.

4. Pixelstruktur (100A und 100B) nach Anspruch 1, **dadurch gekennzeichnet, dass** sich der vertikale Vorsprung des Höckers (114) auf dem Substrat (101) von innerhalb der Durchkontaktierung (110) nach außerhalb der Durchkontaktierung (110) entlang einer Erstreckungsrichtung der Metallschicht (112) erstreckt.

5. Pixelstruktur (100A und 100B) nach Anspruch 1, **dadurch gekennzeichnet, dass** eine Dicke des Höckers (114) T1 ist, eine Dicke der Halbleiterschicht (106) T2 ist und dass 1,5 ≤ (T1/T2) ≤ 5 ist.

6. Pixelstruktur (100A und 100B) nach Anspruch 1, **dadurch gekennzeichnet, dass** eine Dicke des Höckers (114) T1 ist und dass 100 Nanometer ≤ T1 ≤ 250 Nanometer ist.

7. Pixelstruktur (100A und 100B) nach Anspruch 1, **dadurch gekennzeichnet, dass** die erste Isolierschicht (102) und die zweite Isolierschicht (108) jeweils aus einer einzelnen dielektrischen Schicht oder einer Vielzahl von dielektrischen Schichten gebildet sind.

8. Pixelstruktur (100A und 100B) nach Anspruch 1, **dadurch gekennzeichnet, dass** mindestens ein Abschnitt der Metallschicht (112) als eine Datenleitung angepasst ist und sich der mindestens eine Abschnitt der Halbleiterschicht (106) in dieselbe Richtung erstreckt, wie sich die Datenleitung erstreckt

9. Pixelstruktur (100A und 100B) nach Anspruch 8, **dadurch gekennzeichnet, dass** der mindestens eine Abschnitt der Halbleiterschicht (106) mit der Metallschicht (112) in einer zu dem Substrat (101) senkrechten Richtung überlappend angeordnet ist.

10. Pixelstruktur (100A und 100B) nach Anspruch 1, **gekennzeichnet dadurch, dass** sie ferner Folgendes umfasst:
eine lichtabschirmende Schicht (136), die oberhalb des Substrats (101) und oberhalb des Höckers (114) angeordnet ist, wobei sich die Metallschicht (112) zwischen der lichtabschirmenden Schicht (136) und dem Höcker (114) befindet.

11. Anzeigevorrichtung (200), **dadurch gekennzeichnet, dass** sie Folgendes umfasst:
ein Anzeigefeld (202) mit einer Anzeigezone (204) und einer peripheren Zone (206), wobei die periphere Zone (206) benachbart zu der Anzeigezone (204) ist; und
die Pixelstruktur (208) nach Anspruch 1, die innerhalb der Anzeigezone (204) angeordnet ist.

## Revendications

1. Structure de pixel (100A et 100B), disposée sur un substrat (101), et comprenant :
un bossage (114), disposé sur le substrat (101) ;
une première couche d'isolation (102), disposée sur le substrat (101) et recouvrant le bossage (114), la première couche d'isolation (102) présentant une partie saillante (104) où la première couche d'isolation (102) recouvre le bossage (114) ;
une couche semiconductrice (106), disposée sur le substrat (104) ;
une deuxième couche d'isolation (108), disposée sur la première couche d'isolation (102) et la couche semiconductrice (106), la deuxième couche d'isolation (108) présentant un passage (110) positionné au-dessus de la partie saillante (104) et exposant la couche semiconductrice (106) ;
une couche métallique (112), disposée sur la deuxième couche d'isolation (108) et connectée électriquement à la couche semiconductrice (106) par le biais du passage (110), le bossage (114) étant présent dans une saillie verticale de la couche métallique (112) sur le substrat (101) ; et
une électrode à pixel (130), connectée électriquement à la couche semiconductrice (106), **caractérisé en ce que** le bossage (114) est formé d'un matériau de protection contre la lumière.

2. Structure de pixel (100A et 100B) selon la revendication 1, **caractérisée en ce qu'**elle comprend en outre :
une couche de planarisation (116), recouvrant la couche métallique (112) et la deuxième couche d'isolation (108), le bossage (114) étant situé entre le substrat (101) et la couche de planarisation (116), la couche de planarisation (116) présentant une partie concave (118), la partie concave (118) étant située sur une surface supérieure (S) de la couche de planarisation (116) opposée à la couche métallique (112), la partie concave (118) étant au moins partiellement chevauchée par le passage (110), et une profondeur maximale de la partie concave (118) étant de moins de 100 nanomètres.

3. Structure de pixel (100A et 100B) selon la revendication 1, **caractérisée en ce qu'**elle comprend en outre :
une couche de planarisation (116), recouvrant la couche métallique (112) et la deuxième couche d'isolation (108), le bossage (114) étant situé entre le substrat (101) et la couche de planarisation (116) ; et
une couche de support d'affichage (132), disposée sur la couche de planarisation (116), présentant une pluralité de supports d'affichage (134).

4. Structure de pixel (100A et 100B) selon la revendication 1, **caractérisée en ce que** la saillie verticale du bossage (114) sur le substrat (101) s'étend de l'intérieur du passage (110) vers l'extérieur du passage (110) dans une direction d'extension de la couche métallique (112).

5. Structure de pixel (100A et 100B) selon la revendication 1, **caractérisée en ce que** l'épaisseur du bossage (114) est T1, une épaisseur de la couche semiconductrice (106) est T2, et 1,5 ≤ (T1/T2) ≤ 5.

6. Structure de pixel (100A et 100B) selon la revendication 1, **caractérisée en ce que** l'épaisseur du bossage (114) est T1, et 100 nanomètres ≤ T1 ≤ 250 nanomètres.

7. Structure de pixel (100A et 100B) selon la revendication 1, **caractérisée en ce que** la première couche d'isolation (102) et la deuxième couche d'isolation (108) sont respectivement formées d'une couche diélectrique unique ou d'une pluralité de couches diélectriques.

8. Structure de pixel (100A et 100B) selon la revendication 1, **caractérisée en ce qu'**au moins une partie de la couche métallique (112) est conçue comme ligne de données et l'au moins une partie de la couche semiconductrice (106) s'étend dans la même direction que la ligne de données s'étend.

9. Structure de pixel (100A et 100B) selon la revendication 8, **caractérisée en ce que** l'au moins une partie de la couche semiconductrice (106) est disposée en recouvrement de la couche métallique (112) dans une direction perpendiculaire au substrat (101).

10. Structure de pixel (100A et 100B) selon la revendication 1, **caractérisée en ce qu'**elle comprend en outre :
une couche de protection contre la lumière (136), disposée au-dessus sur le substrat (101) et au-dessus du bossage (114), la couche métallique (112) étant située entre la couche de protection contre la lumière (136) et le bossage (114).

11. Dispositif d'affichage (200), **caractérisé en ce qu'**il comprend :
un panneau d'affichage (202), présentant une zone d'affichage (204) et une zone périphérique (206), la zone périphérique (206) étant adjacente à la zone d'affichage (204) ; et
la structure de pixel (208) selon la revendication 1, disposée à l'intérieur de la zone d'affichage (204).
